# EUROPEAN PATENT SPECIFICATION

(11) **EP 2 793 540 B1**
(45) Date of publication and mention of the grant of the patent: **13.02.2019**
(21) Application number: 14164358.5
(22) Date of filing: 11.04.2014
(51) Int. Cl.: H05K 7/14, H02B 1/04

(54) **Motor drive device and motor drive system**
Motorantriebsvorrichtung und Motorantriebssystem
Dispositif et système d'entraînement de moteur

(30) Priority: 15.04.2013 JP 2013084643
(43) Date of publication of application: 22.10.2014
(73) Proprietor: Kabushiki Kaisha Yaskawa Denki, Kitakyushu-shi, Fukuoka 806-0004 (JP)
(72) Inventor: Maeda, Takashi, Kitakyushu-shi, Fukuoka 806-0004 (JP); Hashimoto, Yoichi, Kitakyushu-shi, Fukuoka 806-0004 (JP); Nomura, Kenji, Kitakyushu-shi, Fukuoka 806-0004 (JP)
(74) Representative: Viering, Jentschura & Partner mbB Patent- und Rechtsanwälte

(56) References cited:
- EP-A2- 0 207 496
- WO-A1-2012/117609
- DE-A1- 19 810 842
- US-A- 5 742 143
- US-A- 5 930 112
- US-A1- 2004 201 972

## Description

### Technical Field

The disclosed embodiment relates to a motor drive device and a motor drive system.

### Background of the Invention

Conventionally, for example, WO2012/117609A1 discloses a motor drive device which drives a plurality of motors. This conventional motor drive device is provided with a control circuit board and a power circuit board which is separately provided from the control circuit board. The control circuit board is provided with a signal line of a lower voltage system (hereinafter, referred to as "the low-voltage system") used for signaling with a servo controller which controls the motors. Meanwhile, the power circuit board is provided with a higher voltage system (hereinafter, referred to as "the high-voltage system") which supplies higher voltage to an amplifier module. In this conventional technology, for example, reliability of insulation and reliability against noise can be secured by arranging the high-voltage system and the low-voltage system on separate substrates, as described above.

However, in the motor drive device disclosed in WO2012/117609A1, the circuits of the control circuit board and the power circuit board are each comprised of a printed circuit having a thin film made of a conducting material (for example, a copper foil). As a result, as electric current which flows through the power circuit board in order to supply the current to the amplifier module increases, it is necessary to increase a required surface area and/or a required thickness of the thin film and, thus, the size of the power circuit board also increases. Therefore, the entire size of the device will be increased.

DE 19810842 A1 discloses a motor drive device for driving at least one motor, comprising: at least one amplifier module for supplying power to the at least one motor; and a control circuit board including at least one amplifier connector for releasably connecting with the at least one amplifier module, respectively.

### Summary of the Invention

According to the present invention, a motor drive device according to claim 1 is provided. A motor drive system according to the present invention is defined in claim 8. The dependent claims show some examples of such a motor drive device. The present disclosure provides a motor drive device, which can supply large current to an amplifier module, while preventing an increase in the entire size of the device.

According to one aspect of the present disclosure, a motor drive device for driving at least one motor is provided, which includes at least one amplifier module for supplying power to the at least one motor, a control circuit board including at least one amplifier connector for releasably connecting with the at least one amplifier module, respectively, and a bus bar for releasably connecting with the amplifier module to supply power to the amplifier module.

### Effect of the Invention

According to the motor drive device of this disclosure, large current can be supplied to the amplifier module(s), while preventing an increase in the entire size of the device.

### Brief Description of the Drawings

The present disclosure is illustrated by way of example and not by way of limitation in the figures of the accompanying drawings, in which the like reference numerals indicate like elements and in which:
Fig. 1 is a perspective view illustrating an example configuration of a motor drive device according to one embodiment, where the total of five amplifier modules are mounted onto a control circuit board which is formed by mutually coupling two units (a first unit and a second unit);
Fig. 2 is a perspective view illustrating a state where the first unit is removed from the configuration illustrated in Fig. 1, and two of the three amplifier modules of the second unit are further removed;
Fig. 3 is a perspective view illustrating the detailed structure of a one-axis amplifier module and a two-axes amplifier module;
Fig. 4 is a perspective view illustrating a state where a covering body is removed from the amplifier module mounted onto the control circuit board illustrated in Fig. 2, the covering body being to cover the right side and the upper side of the amplifier module;
Fig. 5 is a view illustrating connections of a connector for a positive-side power and a connector for a negative-side power of the amplifier module with a positive-side bus bar section and a negative-side bus bar section of a bus bar;
Fig. 6 is a perspective view illustrating a mode in which the amplifier module is connected to the positive-side bus bar section and the negative-side bus bar section via the connector for the positive-side power and the connector for the negative-side power, respectively;
Fig. 7 is a system configuration diagram schematically illustrating the entire configuration of a motor drive system which uses the motor drive device of this embodiment; and
Figs. 8A to 8G are views illustrating example combinations of the first unit and the second unit.

### Detailed Description

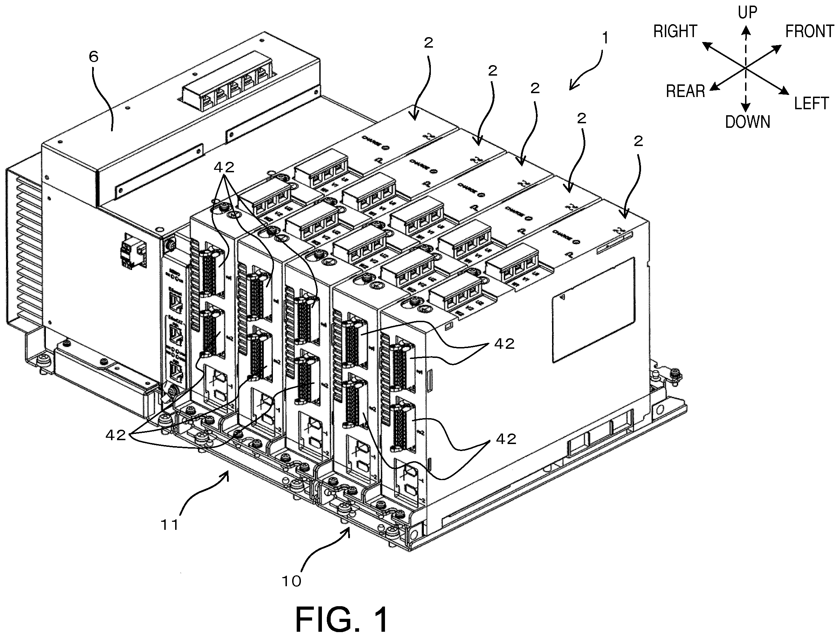

Hereinafter, one embodiment will be described with reference to the accompanying drawings. Note that, in the following description, up and down, front and rear, and left and right correspond to arrow directions which are suitably illustrated, for example, in Figs. 1 to 6, unless the directions are particularly specified.

### <Outline of Motor Drive Device>

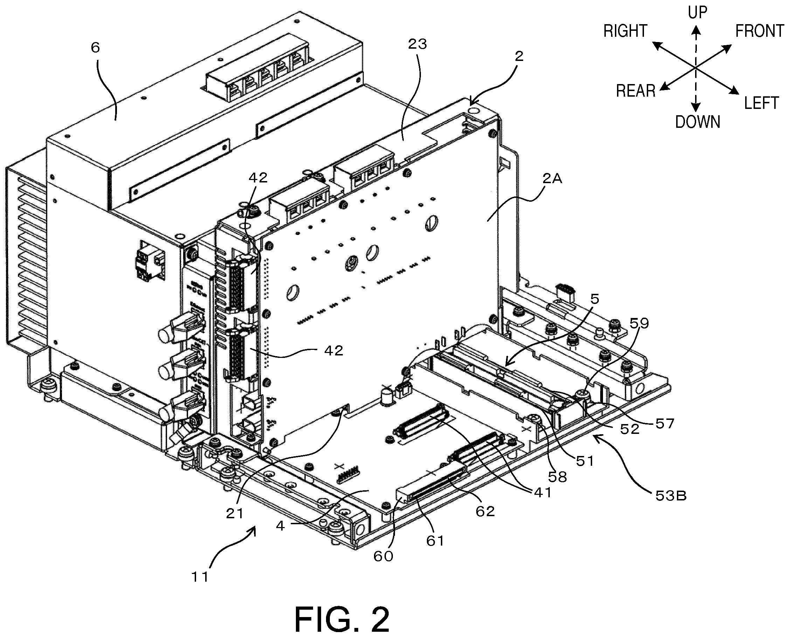

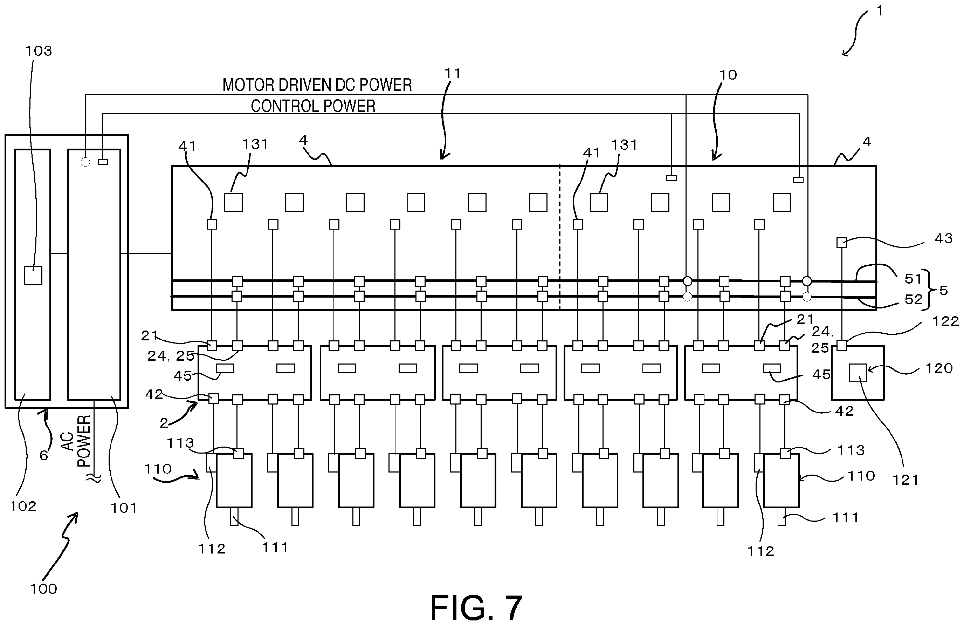

As illustrated in Figs. 1 and 2, a motor drive device 1 of this embodiment includes at least one amplifier module 2 (in this example, five amplifier modules are arrayed in the left-to-right direction) which supplies power to motors 110 (see Fig. 7 described later), a control circuit board 4 extending in a substantially horizontal direction and to which one or more amplifier modules 2 are releasably installed from above, a bus bar 5 extending in the left-to-right direction on the control circuit board 4 and for supplying power to the amplifier modules 2, a converter device 6, and a control module 120 (see Fig. 7 described later).

In the example illustrated in Fig. 1, two control circuit boards 4 are arranged in the left-to-right direction. A first unit 10 is comprised of a left control circuit board 4 of the two control circuit boards 4, a bus bar 5 provided to the left control circuit board 4, and two amplifier modules 2 connected to the left control circuit board 4. Similarly, a second unit 11 is comprised of a right control circuit board 4 of the two control circuit boards 4, a bus bar 5 provided to the right control circuit board 4, and three amplifier modules 2 connected to the right control circuit board 4. Note that the control circuit board 4 of the first unit 10 and the control circuit board 4 of the second unit 11 are mutually connected in the left-to-right direction via circuit board connectors (described later in detail).

In the second unit 11, three amplifier connectors 41 are arrayed in the left-to-right direction, in a substantially central part of the control circuit board 4 in the front-to-rear direction. The three amplifier modules 2 are mounted to the three amplifier connectors 41, respectively (also see Fig. 7 described later). Similarly, in the first unit 10, although the detailed illustration is omitted, two amplifier connectors 41 are arrayed in the left-to-right direction, in a substantially central part of the control circuit board 4 in the front-to-rear direction. The two amplifier modules 2 are mounted to the two amplifier connecters 41, respectively (also see Fig. 7 described later).

### <Amplifier Module>

Each of the amplifier modules 2 has a box-shaped contour of which the thickness is thin in the left-to-right direction. One mounting connector 21 which can be releasably mounted to the amplifier connector 41 is provided in a central part of a lower end part of each amplifier module 2 in the front-to-rear direction. Each amplifier module 2 is releasably connected to the control circuit board 4 by mounting the mounting connector 21 to the amplifier connector 41 of the control circuit board 4.

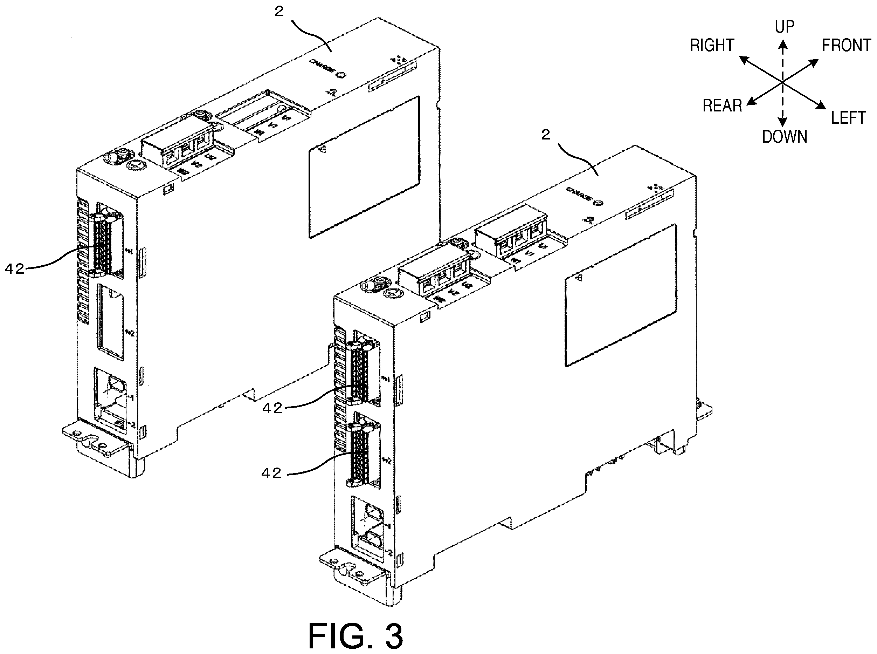

As for the amplifier modules 2, a two-axes amplifier module (hereinafter, it may suitably be simply referred to as "the two-axes amplifier module 2") illustrated on the front right side in Fig. 3, and a one-axis amplifier module (hereinafter, it may suitably be simply referred to as "the one-axis amplifier module 2") illustrated in the rear left side in Fig. 3 are prepared in advance.

The two-axes amplifier module 2 has two motor connectors 42 in an end face on the rear side (the front left side in Fig. 3) to supply power to two motors 110 via the motor connectors 42, respectively (also see Fig. 7 described later). The one-axis amplifier module 2 has one motor connector 42 in an end face on the rear side (the front left side in Fig. 3) to supply power to one motor 110 via the one motor connector 42.

Note that, below, in this embodiment, a case where all the five amplifier modules 2 are the two-axes amplifier modules 2 will be described as an example.

### <Bus Bar>

The bus bar 5 includes a positive-side (P-side) bus bar section 51 which supplies positive (plus) direct current (corresponding to a first DC power) and a negative-side (N-side) bus bar section 52 which supplies negative (minus) direct current (corresponding to a second DC power), as illustrated in Fig. 2. Each of the positive-side bus bar section 51 and the negative-side bus bar section 52 has a plate shape or a belt shape which stands upward from the control circuit board 4. The positive-side bus bar section 51 and the negative-side bus bar section 52 extend in the left-to-right direction, spaced apart from each other at positions forward from the amplifier connector 41 on the control circuit board 4.

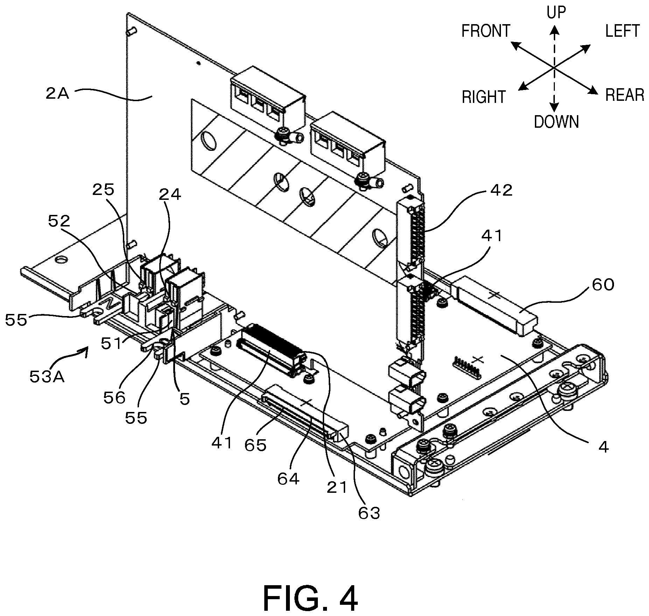

Fig. 4 illustrates a state where a covering body 23 is removed from the amplifier module mounted onto the control circuit board 4 illustrated in Fig. 2, where the covering body 23 is to cover the amplifier module 2 from the right side and the upper side. As illustrated in Figs. 4 and 2, a module circuit board 2A is vertically provided to each of the amplifier modules 2. The connector 24 for the positive-side power (corresponding to the DC power supply connector) and the connector 25 for the negative-side power (corresponding to the DC power supply connector) are provided so as to project rightward from a lower part of a front area of the module circuit board 2A.

As illustrated in Fig. 4, the connector 24 for the positive-side power is connected with the positive-side bus bar section 51 of the bus bar 5, while the connector 25 for the negative-side power is connected with the negative-side bus bar section 52 of the bus bar 5, and the mounting connector 21 is further connected with the amplifier connector 41, thereby, the module circuit board 2A (in other words, the amplifier module 2) is mounted to the control circuit board 4 at a lower end part thereof.

### <Connection of Connectors for Positive-side and Negative-side Power and Amplifier Connector with Bus Bar>

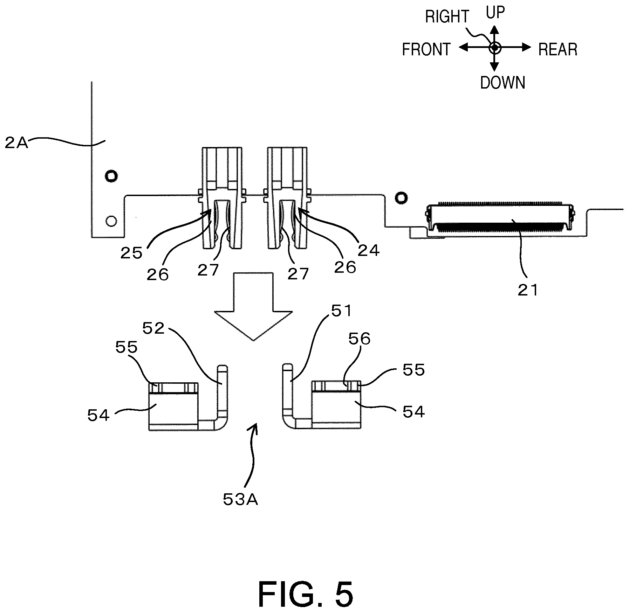

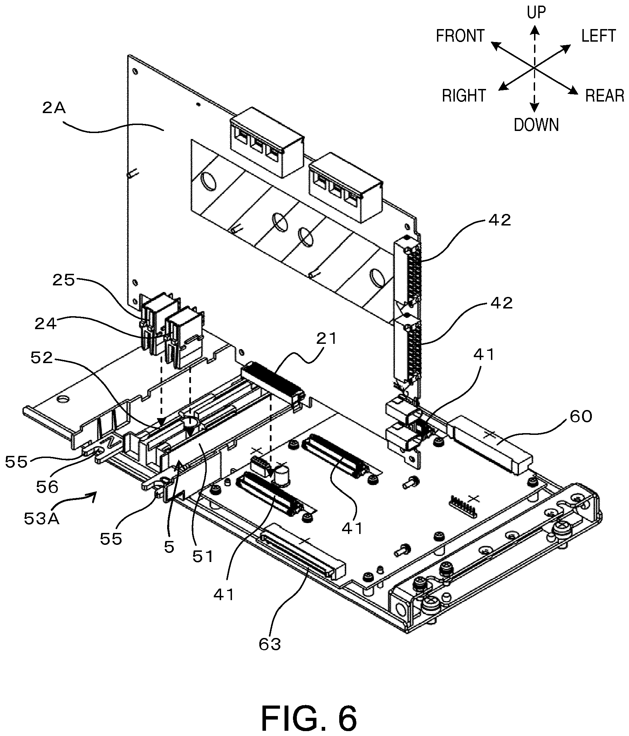

As illustrated in Fig. 5, the connector 24 for the positive-side power and the connector 25 for the negative-side power are each provided with a contact 26 made from, for example, a conducting metal plate having an inverted U-shape in a front view where an opening of the U-shape is narrower toward a tip-end thereof. A leaf spring 27, which is formed by, for example, bending a conducting metal plate, is provided over both side faces inside the contact 26. As illustrated in Fig. 6, the module circuit board 2A (in other words, the amplifier module 2) is lowered toward the control circuit board 4, and the connector 24 for the positive-side power and the connector 25 for the negative-side power of the amplifier module 2 are then pressed against the positive-side bus bar section 51 and the negative-side bus bar section 52 of the bus bar 5 of the control circuit board 4, respectively. Thus, the contacts 26 of the inverted U-shape of the connector 24 for the positive-side power and the connector 25 for the negative-side power pinch the positive-side bus bar section 51 and the negative-side bus bar section 52 of the bus bar 5 from both sides, respectively. As a result, the connector 24 for the positive-side power and the connector 25 for the negative-side power are connected with the positive-side bus bar section 51 and the negative-side bus bar section 52, respectively, into a state where the connectors are prevented from escaping from the contacts 26 by the elasticity of the leaf springs 27 located inside the contacts 26. Here, substantially simultaneously, the mounting connector 21 is releasably connected with the amplifier connector 41 by pressing the mounting connector 21 located in the lower end part of the module circuit board 2A against the amplifier connector 41 of the control circuit board 4.

### <Coupling of Bus Bars>

Here, the bus bar 5 of each unit is provided with coupling mechanisms at both ends thereof in the left-to-right direction (in other words, its extending direction), which enable the bus bar 5 to connect with other adjacent bus bars 5. That is, as illustrated in Figs. 4 and 5, a coupling mechanism part 53A which constitutes one of the coupling mechanisms is provided to the right end of the bus bar 5 (a front left side in Fig. 4, and the front side of the drawing sheet of Fig. 5).

The coupling mechanism part 53A includes receptacle parts 54, each of which is raised in a hook shape in the front-to-rear direction from a lower part of a right end part of the positive-side bus bar section 51 and the negative-side bus bar section 52, respectively, and a tip-end part 55 of a substantially U-shape which is provided so as to project rightward from an upper end of each receptacle part 54. The tip-end part 55 has an opening 56 which opens rightward.

On the other hand, as illustrated in Fig. 2, a coupling mechanism part 53B which constitutes the other coupling mechanism is provided to the left end of the bus bar 5 (front right side in Fig. 2).

The coupling mechanism part 53B includes tab parts 57, each of which is raised in a hook shape in the front-to-rear direction from a lower part on the left side of the positive-side bus bar section 51 and the negative-side bus bar section 52, respectively, a boss 58 formed at an upper end of each tab part 57 and having a tapped hole, and screws 59 which threadedly engage with the tapped holes of the bosses 58.

In the above configuration, when connecting the bus bar 5 of one unit with the bus bar 5 of another unit, the tip-end parts 55 of the coupling mechanism part 53B of the one unit on the positive-side bus bar section 51 side and the negative-side bus bar section 52 side are placed on the bosses 58 of the coupling mechanism part 53A of the other unit on the positive-side bus bar section 51 side and the negative-side bus bar section 52 side. Then, the screw 59 inserted into the opening 56 of each tip-end part 55 is threadedly engaged with the tapped hole of each boss 58 to fix the tip-end part 55 to the boss 58 via the screw 59.

### <Coupling of Control Circuit Boards>

The control circuit board 4 of each unit is provided with a circuit board connector to connect with the control circuit board 4 of another unit. That is, as illustrated in Fig. 2, one circuit board connector 60 is provided to a left edge part (front right side in Fig. 2) of the control circuit board 4 of each unit, at a position relatively rearward in this example. Corresponding to this, as illustrated in Fig. 4, the other circuit board connector 63 is provided to a right edge part (front left side in Fig. 4) of the control circuit board 4, at a position relatively rearward in this example.

The one circuit board connector 60 is formed with a fitting opening 61 of a substantially rectangular shape extending in the front-to-rear direction, and an insertion plate 62 extending in the front-to-rear direction is provided in a central part of the fitting opening 61 in the height direction.

The other circuit board connector 63 is provided with a fitting part 64 of a substantially rectangular parallelepiped shape extending in the front-to-rear direction, and a receptor hole 65 extending in the front-to-rear direction is formed in the fitting part 64.

In the above configuration, when connecting the control circuit board 4 of one unit with the control circuit board 4 of the other unit, the fitting part 64 of the other circuit board connector 63 of the other unit is inserted into the fitting opening 61 of the one circuit board connector 60 of the one unit so that the insertion plate 62 of the fitting opening 61 is inserted and fixed into the receptor hole 65 of the fitting part 64.

Note that, in the above, the tip-end part 55 of the coupling mechanism part 53B and the boss 58 of the coupling mechanism part 53A are fastened and fixed with the screw 59 after the tip-end part 55 is vertically overlapped with the boss 58. However, alternatively, it may adopt a so-called one-touch coupling structure in which the bus bars 5 of the two adjacent units are mutually connected by using suitable connectors (not illustrated), substantially simultaneously with the control circuit boards 4 being mutually coupled and fixed by the circuit board connectors 60 and 63 as described above. In this case, since the bus bars 5 of the units can also be mutually connected, substantially at the same time as the mutual connection of the control circuit boards 4 of the units, a burden of user's work can be reduced and the convenience of the motor drive device 1 can be improved.

### <System Configuration>

Fig. 7 illustrates the entire electrical configuration of a motor drive system 100 provided with the motor drive device 1 of the configuration described earlier. As illustrated in Fig. 7, the motor drive system 100 includes ten motors 110 and the motor drive device 1 described above.

Each motor 110 has an encoder 112 which detects a rotation angle of a rotating body such as a rotation shaft 111 of the motor 110 and outputs a detected rotation angle as a position detection signal.

### <Outline of Electrical Configuration of Motor Drive Device>

The motor drive device 1 has a converter device 6 described above, five amplifier modules 2 which supply power to ten motors 110, and a control module 120.

The converter device 6 includes a converter module 101 and a capacitor module 102. The converter module 101 generates and outputs motor drive DC power (for example, +300VDC) and control power (for example, +5VDC or ±12VDC) in response to an input of AC power (for example, 200VAC). The capacitor module 102 has a capacitor 103 mounted thereon. The capacitor 103 smoothes the motor drive DC power generated by the converter module 101.

Each amplifier module 2 has the two motor connectors 42 described above which can releasably connect with the connectors (illustration is omitted) of motor cables for connecting with two motors 110. One of the connectors of the motor cable is fitted to each motor connector 42, while the other connector of the motor cable is fitted to the connector 113 of one motor 110. Thus, one amplifier module 2 is connected with two motors 110 to drive the two motors 110. That is, in response to the inputs of the position detection signals from the encoders 112 of the two motors 110, the amplifier module 2 generates corresponding signals, and then outputs the generated signals to the control circuit board 4 of the first unit 10 (or the second unit 11). Note that, below, the control circuit board 4 of the first unit 10 and the control circuit board 4 of the second unit 11 may simply be referred to as "the control circuit board(s) 4" without particularly distinguishing one control circuit board from the other.

Note that the capacities (output powers) of the motors 110 connected to the respective amplifier modules 2 may be identical or different from each other, and the amplifier modules 2 are configured to have substantially identical external dimensions, regardless of the capacities of the corresponding motors 110.

The control module 120 has a CPU 121 mounted thereon, and the CPU 121 is associated with a memory. The CPU 121 distributes and outputs a motor control reference (any one of control references such as the position, speed and torque), which is read and outputted from the memory, over/to ten controlling processors 131 of the control circuit board 4.

### <Details of Electrical Configuration of Control Circuit Board>

The control power from the converter module 101 is inputted into the control circuit board 4. In the control circuit board 4, the ten controlling processors 131 (control IC), the five amplifier connectors 41 with which the five amplifier modules 2 are releasably connected, respectively, a control module connector 43 with which the control module 120 is releasably connected, and signal lines (illustration is omitted) for controlling switching elements 45 of each amplifier module 2 based on the motor control reference from the control module 120, are arranged.

Voltage of a low-voltage system (for example, +5VDC or ±12VDC) used for control-signaling of each amplifier module 2 is supplied to the control circuit board 4. That is, the control circuit board 4 is connected with each amplifier module 2 by fitting the mounting connector 21 of the amplifier module 2 to each amplifier connector 41. The control circuit board 4 is connected with the control module 120 by fitting the connector 122 of the control module 120 to the control module connector 43.

Here, the controlling processor 131 of each control circuit board 4 is comprised of, for example, an IC chip, and corresponds to each motor, respectively. Each controlling processor 131 performs a control operation (including a current control operation) according to the inputted motor control reference in response to the motor control reference from the control module 120 and the input of the position detection signal from the encoder 102 of each motor 100. Then, each controlling processor 131 outputs a switching reference based on the control operation to the switching elements 45 of the amplifier module 2 via the amplifier connectors 41.

The bus bar 5 described above, which is a power line of a high-voltage system (for example, +300VDC) is provided to the control circuit board 4. Motor drive direct current from the converter module 101 is inputted into the bus bar 5. The power is supplied to each amplifier module 2 by connecting the connector 24 for the positive-side power and the connector 25 for the negative-side power of the five above-described amplifier modules 2 with the positive-side bus bar section 51 and the negative-side bus bar section 52 of the bus bar 5, respectively.

By the above configuration, the motor drive device 1 supplies power to the ten motors 110 connected with the five amplifier modules 2, respectively, according to the motor control reference outputted from the control module 120 to drive each motor 110.

### <Effects of Embodiment>

As described above, the motor drive device 1 of this embodiment includes the plurality of amplifier modules 2, the control circuit board 4, and the bus bar 5. The control circuit board 4 is provided with the plurality of amplifier connectors 41. Each amplifier module 2 is connected with the control circuit board 4 by using the respective amplifier connectors 41. Thus, the switching elements 45 of each amplifier module 2 are controlled by the signals from the control circuit board 4.

Here, supply of the power to each amplifier module 2 is performed by the bus bar 5. By connecting the amplifier modules 2 to the bus bar 5, power can be simultaneously supplied to the amplifier modules 2. Thus, even if large current flows, it will be unnecessary to have a large surface area or a large thickness of a thin film like when the thin film made of the conducting material is used, because the power supply to the amplifier module 2 is performed using the bus bar 5 having a large cross-sectional area. As a result, it can prevent the motor drive device 1 from increasing in size and, thus, the entire size of the motor drive device 1 can be comparatively small.

Especially in this embodiment, the amplifier module 2 includes the connector(s) 24 for the positive-side power and the connector(s) 25 for the negative-side power connectable with the positive-side bus bar section 51 which supplies the positive-side direct current of the bus bar 5, and the negative-side bus bar section 52 which supplies the negative-side direct current of the bus bar 5, respectively. Thus, power can certainly be supplied to the amplifier modules 2.

Further, especially in this embodiment, the motor drive device 1 is comprised of a plurality of mutually-coupled units, where each unit (for example, the first unit 10 or the second unit 11) includes the control circuit boards 4, the bus bar 5, and the amplifier modules 2 connected with the control circuit board 4 and the bus bar 5. The bus bar 5 of one unit has at both ends in the left-to-right direction the coupling mechanism parts 53A and 53B which are connectable with the bus bars 5 of the other units.

Thus, the motor drive device 1 is comprised of a plurality of mutually coupled units, each unit having the control circuit board 4, the bus bar 5, and amplifier modules 2. Thus, desired types and the number of units can be used by coupling the units according to the application of the device and the needs of a user and, thus, flexibility and versatility of the device can be improved.

Especially in this embodiment, the control circuit board 4 of one unit includes the circuit board connectors 60 and 63 through which the control circuit board 4 can be connected with the control circuit boards 4 of the other units.

Thus, if the plurality of units are connected as described above to constitute the motor drive device 1, the control circuit boards 4 of the units can smoothly be connected with each other.

Especially in this embodiment, the plurality of units include at least one first unit 10 each having the control circuit board 4 provided with two amplifier connectors 41 to releasably connect with two amplifier modules 2, and at least one second unit 11 having the control circuit board 4 provided with three amplifier connectors 41 to releasably connect with three amplifier modules 2. The at least one first unit 10 and the at least one second unit 11 are coupled to each other.

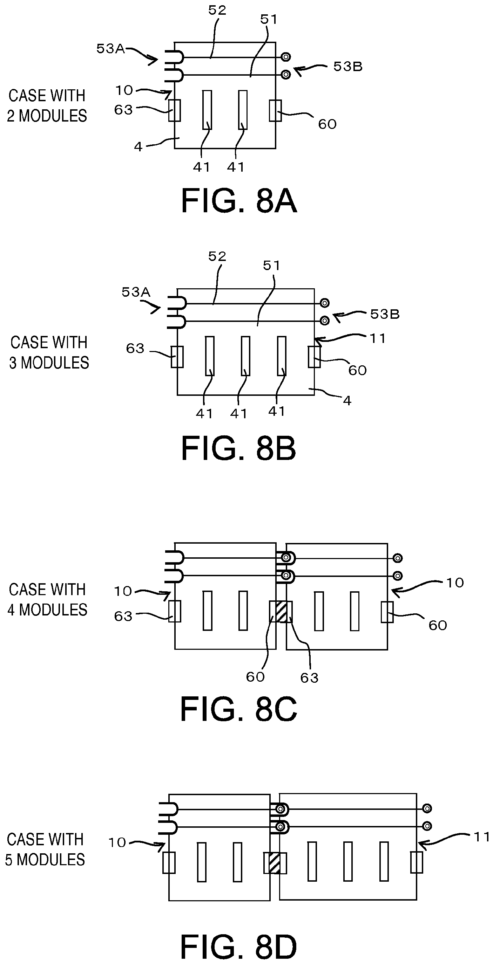

In this embodiment, the first unit 10 can be connected with the two amplifier modules 2 by having the two amplifier connectors 41. The second unit 11 can be connected with the three amplifier modules 2 by having the three amplifier connectors 41. Thus, since the unit has two types of units, the first unit 10 and the second unit 11, the number of the amplifier modules 2 to be controlled can be varied, when a plurality of units are coupled to constitute the motor drive device 1 as described above. Figs. 8A to 8G illustrate the effects further in detail.

Fig. 8A illustrates a case where the number of amplifier modules 2 to be controlled is two. In this case, a single first unit 10 is used independently. The control circuit board 4 of the first unit 10 includes the bus bar 5 (the positive-side bus bar section 51 and the negative-side bus bar section 52) and two amplifier connectors 41 connectable with the two amplifier modules 2 (illustration of the amplifier modules is omitted in Figs. 8A to 8G). Power from the high-voltage system is supplied to the two amplifier modules 2 through the bus bar 5, and power from the low-voltage system is supplied to the two amplifier modules 2 through the two amplifier connectors 41.

Fig. 8B illustrates a case where the number of amplifier modules 2 to be controlled is three. In this case, a single second unit 11 is used independently. The control circuit board 4 of the second unit 11 includes the bus bar 5 and three amplifier connectors 41 connectable with three amplifier modules 2. Power from the high-voltage system is supplied to the three amplifier modules 2 through the bus bar 5, and power from the low-voltage system is supplied to the three amplifier modules 2 through the three amplifier connectors 41.

Fig. 8C illustrates a case where the number of amplifier modules 2 to be controlled is four. In this case, two first units 10 are used by coupling the units via the connectors 60 and 63. Note that a connected part of the two adjacent units by the connector 60 and the connector 63 is represented by hatching (the same for Figs. 8C to 8G). The assembly of the two first units 10 includes four amplifier connectors 41 connectable with four amplifier modules 2, and the bus bars 5 of the two units are conductive therebetween through the coupling mechanisms 53A and 53B described above and, thus, the units are electrically integrated. Power from the high-voltage system is supplied to the four amplifier modules 2 through the integrated bus bar 5, and power from the low-voltage system is supplied to the four amplifier modules 2 through the four amplifier connectors 41.

Fig. 8D illustrates a case where the number of amplifier modules 2 to be controlled is five. In this case, a single first unit 10 and a single second unit 11 are used by coupling the units to each other via the connectors 60 and 63. The assembly of the two units 10 and 11 includes five amplifier connectors 41 connectable with five amplifier modules 2, and the bus bars 5 of the two units are conductive therebetween through the coupling mechanisms 53A and 53B described above and, thus, the units are electrically integrated. Power from the high-voltage system is supplied to the five amplifier modules 2 through the integrated bus bar 5, and power from the low-voltage system is supplied to the five amplifier modules 2 through the five amplifier connectors 41.

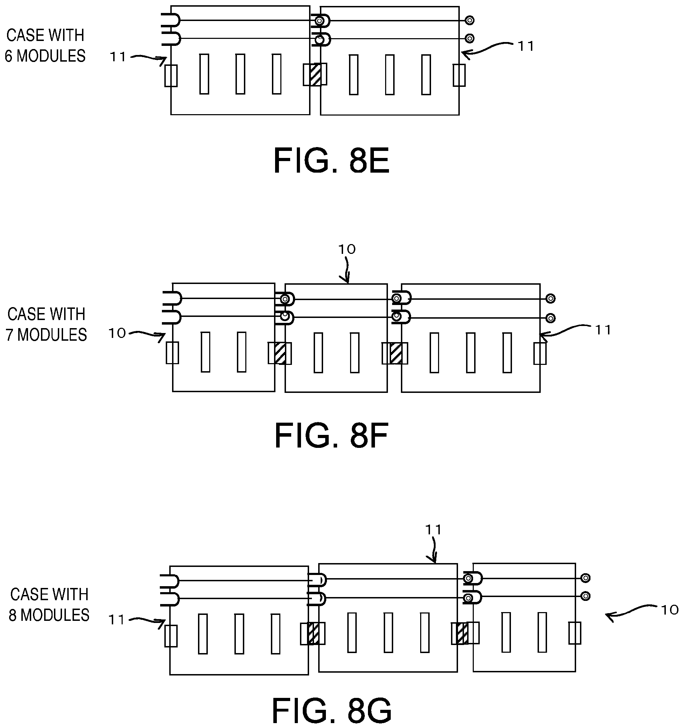

Fig. 8E illustrates an example case where the number of amplifier modules 2 to be controlled is six. In this example, two second units 11 are used by coupling the units to each other via the connectors 60 and 63. The assembly of the two second units 11 includes six amplifier connectors 41 connectable with six amplifier modules 2, and the bus bars 5 of the two units are conductive therebetween through the coupling mechanisms 53A and 53B described above and, thus, the units are electrically integrated. Power from the high-voltage system is supplied to the six amplifier modules 2 through the integrated bus bar 5, and power from the low-voltage system is supplied to the six amplifier modules 2 through the six amplifier connectors 41. Note that, in such a case, three first units 10 may be used by coupling the units to each other.

Fig. 8F illustrates an example case where the number of amplifier modules 2 to be controlled is seven. In this example, two first units 10 and a single second unit 11 are used by coupling the units to each other via the connectors 60 and 63. The assembly of the three units 10 and 11 includes seven amplifier connectors 41 connectable with seven amplifier modules 2, and the bus bars 5 of the three units are conductive thereamong through the coupling mechanisms 53A and 53B described above and, thus, the units are electrically integrated. Power from the high-voltage system is supplied to the seven amplifier modules 2 through the integrated bus bar 5, and power from the low-voltage system is supplied to the seven amplifier modules 2 through the seven amplifier connectors

Fig. 8G illustrates an example case where the number of amplifier modules 2 to be controlled is eight. In this example, two second units 11 and a single first unit 10 are used by coupling the units to each other via the connectors 60 and 63. The assembly of the three units 11 and 10 includes eight amplifier connectors 41 connectable with eight amplifier modules 2, and the bus bars 5 of the three units are conductive thereamong through the coupling mechanisms 53A and 53B described above and, thus, the units are electrically integrated. Power from the high-voltage system is supplied to the eight amplifier modules 2 through the integrated bus bar 5, and power from the low-voltage system is supplied to the eight amplifier modules 2 through the eight amplifier connectors 41. Note that, in such a case, four first units 10 may also be used by coupling to each other.

Similarly, even if the number of amplifier modules 2 to be controlled is nine or more, one or more first units 10 and one or more second units 11 can suitably be combined to form various combinations of the amplifier modules 2.

## Claims

1. A motor drive device (1) for driving at least one motor (110), comprising:
at least one amplifier module (2) for supplying power to the at least one motor (110); and
a control circuit board (4) including at least one amplifier connector (41) for releasably connecting with the at least one amplifier module (2), respectively;
**characterized by**
a bus bar (5) for releasably connecting with the amplifier module (2) to supply power to the amplifier module (2),
wherein the motor drive device (1) comprises a plurality of mutually coupled units (10, 11), each unit being comprised of the control circuit board (4), the bus bar (5), and the amplifier module (2) connected with the control circuit board (4) and the bus bar (5), and
wherein the bus bar (5) of each of the units (10, 11) includes, at one end or both ends in an extending direction of the bus bar (5), a coupling mechanism (53A, 53B) connectable with the bus bar (5) of another unit (10, 11).

2. The motor drive device (1) of claim 1, wherein the bus bar (5) is provided to the control circuit board (4).

3. The motor drive device (1) of claim 1, wherein the bus bar (5) includes a plurality of bus bars (5), and
wherein the amplifier module (2) includes DC power supply connectors (24, 25) mutually connectable with the plurality of bus bars (5) for supplying first DC power and second DC power.

4. The motor drive device (1) of any of claims 1 to 3, wherein the extending direction is a coupling direction of the units (10, 11).

5. The motor drive device (1) of any of claims 1 to 4, wherein the control circuit board (4) of each of the units (10, 11) includes a circuit board connector (60, 63) mutually connectable with the control circuit board (4) of another unit (10, 11).

6. The motor drive device (1) of claim 5, wherein the coupling mechanism (53A, 53B) of the plurality of units (10, 11) couples the bus bars (5) of the plurality of units (10, 11) to each other when the circuit board connectors (60, 63) of the plurality of units (10, 11) are coupled to each other.

7. The motor drive device (1) of any one of claims 1 to 6, wherein the plurality of units (10, 11) include five amplifier modules (2), the five amplifier modules (2) including:
at least one first unit (10) having the control circuit board (4) provided with two amplifier connectors (41) for releasably connecting with two amplifier modules (2), respectively; and
at least one second unit (11) having the control circuit board (4) provided with three amplifier connectors (41) for releasably connecting with three amplifier modules (2), respectively, and
wherein the at least one first unit (10) and the at least one second unit (11) are coupled to each other.

8. A motor drive system (100), comprising:
at least one motor (110); and
the motor drive device (1) of any one of claims 1 to 6 for driving the motor (110) according to an inputted motor control reference.

## Patentansprüche

1. Eine Motor-Antriebsvorrichtung (1) zum Antreiben mindestens eines Motors (110), aufweisend:
mindestens ein Verstärkermodul (2) zum Bereitstellen von Strom an den mindestens einen Motor (110); und
eine Steuerung-Leiterplatte (4), die mindestens einen Verstärkeranschluss (41) aufweist zum lösbaren Verbinden mit dem mindestens einen Verstärkermodul (2);
**gekennzeichnet durch**
eine Sammelschiene (5) zum lösbaren Verbinden mit dem Verstärkermodul (2), um Strom an das Verstärkermodul (2) bereitzustellen,
wobei die Motor-Antriebsvorrichtung (1) eine Mehrzahl von miteinander verbundenen Einheiten (10, 11) aufweist, wobei jede Einheit aus der Steuerung-Leiterplatte (4), der Sammelschiene (5) und dem mit der Steuerung-Leiterplatte (4) und der Sammelschiene (5) verbundenen Verstärkermodul (2) besteht, und
wobei die Sammelschiene (5) von jeder der Einheiten (10, 11) an einem Ende oder an beiden Enden in einer Erstreckungsrichtung der Sammelschiene (5) einen Verbindungsmechanismus (53A, 53B) aufweist, der mit der Sammelschiene (5) einer anderen Einheit (10, 11) verbunden werden kann.

2. Die Motor-Antriebsvorrichtung (1) gemäß Anspruch 1, wobei die Sammelschiene (5) an der Steuerung-Leiterplatte (4) bereitgestellt ist.

3. Die Motor-Antriebsvorrichtung (1) gemäß Anspruch 1, wobei die Sammelschiene (5) eine Mehrzahl von Sammelschienen (5) aufweist, und
wobei das Verstärkermodul (2) Gleichstrom-Stromversorgungsanschlüsse (24, 25) aufweist, die mit der Mehrzahl von Sammelschienen (5) verbunden werden können, um einen ersten Gleichstrom-Strom und einen zweiten Gleichstrom-Strom bereitzustellen.

4. Die Motor-Antriebsvorrichtung (1) gemäß irgendeinem der Ansprüche 1 bis 3, wobei die Erstreckungsrichtung eine Verbindungsrichtung der Einheiten (10, 11) ist.

5. Die Motor-Antriebsvorrichtung (1) gemäß irgendeinem der Ansprüche 1 bis 4, wobei die Steuerung-Leiterplatte (4) von jeder der Einheiten (10, 11) einen Leiterplattenanschluss (60, 63) aufweist, der mit der Steuerung-Leiterplatte (4) einer anderen Einheit (10, 11) verbunden werden kann.

6. Die Motor-Antriebsvorrichtung (1) gemäß Anspruch 5, wobei der Verbindungsmechanismus (53A, 53B) der Mehrzahl von Einheiten (10, 11) die Sammelschienen (5) der Mehrzahl von Einheiten (10, 11) miteinander verbindet, wenn die Leiterplattenanschlüsse (60, 63) der Mehrzahl von Einheiten (10, 11) miteinander verbunden sind.

7. Die Motor-Antriebsvorrichtung (1) gemäß irgendeinem der Ansprüche 1 bis 6, wobei die Mehrzahl von Einheiten (10, 11) fünf Verstärkermodule (2) aufweist, wobei die fünf Verstärkermodule (2) aufweisen:
mindestens eine erste Einheit (10), deren Steuerung-Leiterplatte (4) mit zwei Verstärkeranschlüssen (41) bereitgestellt ist zum lösbaren Verbinden mit zwei Verstärkermodulen (2); und
mindestens eine zweite Einheit (11), deren Steuerung-Leiterplatte (4) mit drei Verstärkeranschlüssen (41) bereitgestellt ist zum lösbaren Verbinden mit drei Verstärkermodulen (2), und
wobei die mindestens eine erste Einheit (10) und die mindestens eine zweite Einheit (11) miteinander verbunden sind.

8. Ein Motor-Antriebssystem (100), aufweisend:
mindestens einen Motor (110); und
die Motor-Antriebsvorrichtung (1) gemäß irgendeinem der Ansprüche 1 bis 6 zum Antreiben des Motors (110) gemäß einer eingegebenen Motorsteuerungsreferenz.

## Revendications

1. Dispositif de commande de moteur (1) pour commander au moins un moteur (110), comprenant :
au moins un module amplificateur (2) pour fournir la puissance audit au moins un moteur (110) ; et
une carte de circuit de commande (4) comprenant au moins un connecteur d'amplificateur (41) pour une connexion de manière libérable audit au moins un module amplificateur (2), respectivement ;
**caractérisé par**
une barre omnibus (5) pour une connexion de manière libérable au module amplificateur (2) afin d'alimenter le module amplificateur (2) en énergie,
dans lequel le dispositif de commande de moteur (1) comprend une pluralité d'unités mutuellement couplées (10, 11), chaque unité étant composée de la carte de circuit de commande (4), de la barre omnibus (5), et du module amplificateur (2) connecté à la carte de circuit de commande (4) et à la barre omnibus (5), et
dans lequel la barre omnibus (5) de chacune des unités (10, 11) comprend, à une extrémité ou aux deux extrémités dans une direction d'extension de la barre omnibus (5), un mécanisme de couplage (53A, 53B) qui peut être connecté à la barre omnibus (5) d'une autre unité (10, 11).

2. Dispositif de commande de moteur (1) selon la revendication 1, dans lequel la barre omnibus (5) est prévue sur la carte de circuit de commande (4).

3. Dispositif de commande de moteur (1) selon la revendication 1, dans lequel la barre omnibus (5) comprend une pluralité de barres omnibus (5), et
dans lequel le module amplificateur (2) comprend des connecteurs d'alimentation continue (24, 25) qui peuvent être mutuellement connectés à la pluralité de barres omnibus (5) pour fournir une première puissance continue et une deuxième puissance continue.

4. Dispositif de commande de moteur (1) selon l'une quelconque des revendications 1 à 3, dans lequel la direction d'extension est une direction de couplage des unités (10, 11).

5. Dispositif de commande de moteur (1) selon l'une quelconque des revendications 1 à 4, dans lequel la carte de circuit de commande (4) de chacune des unités (10, 11) comprend un connecteur de carte de circuit (60, 63) qui peut être mutuellement connecté à la carte de circuit de commande (4) d'une autre unité (10, 11).

6. Dispositif de commande de moteur (1) selon la revendication 5, dans lequel le mécanisme de couplage (53A, 53B) de la pluralité d'unités (10, 11) couple les barres omnibus (5) de la pluralité d'unités (10, 11) les unes aux autres lorsque les connecteurs de carte de circuit (60, 63) de la pluralité d'unités (10, 11) sont couplés les uns aux autres.

7. Dispositif de commande de moteur (1) selon l'une quelconque des revendications 1 à 6, dans lequel la pluralité d'unités (10, 11) comprend cinq modules amplificateurs (2), les cinq modules amplificateurs (2) comprenant :
au moins une première unité (10) comportant la carte de circuit de commande (4) pourvue de deux connecteurs d'amplificateur (41) pour une connexion de manière libérable à deux modules amplificateurs (2), respectivement ; et
au moins une deuxième unité (11) comportant la carte de circuit de commande (4) pourvue de trois connecteurs d'amplificateur (41) pour une connexion de manière libérable à trois modules amplificateurs (2), respectivement, et
dans lequel ladite au moins une première unité (10) et ladite au moins une deuxième unité (11) sont couplées l'une à l'autre.

8. Système de commande de moteur (100), comprenant :
au moins un moteur (110) ; et
le dispositif de commande de moteur (1) selon l'une quelconque des revendications 1 à 6 pour commander le moteur (110) conformément à une référence de commande de moteur entrée.
